Europäisches Patentamt

European Patent Office

Office européen des brevets

(19)

(11) Publication number: **0 380 340**

**A2**

# EUROPEAN PATENT APPLICATION

(21) Application number: **90300796.1**

(22) Date of filing: **25.01.90**

(51) Int. Cl.5: **H01L 29/91**

(30) Priority: **25.01.89 US 301495**

(43) Date of publication of application:
**01.08.90 Bulletin 90/31**

(84) Designated Contracting States:
**DE FR GB IT NL SE**

(71) Applicant: **CREE RESEARCH, INC.**
**2810 Meridian Parkway, Suite 176**
**Durham, North Carolina 27713(US)**

(72) Inventor: **Palmour, John W.**
**125 Trapper Run Drive**
**Cary, North Carolina 27511(US)**

(74) Representative: **Warren, Keith Stanley et al**
**BARON & WARREN 18 South End Kensington**
**London W8 5BU(GB)**

(54) Silicon carbide Schottky diode and method of making same.

(57) A high performance silicon carbide Schottky contact (14) comprises a platinum containing contact on α-silicon carbide (11,12), specifically 6H-α silicon carbide. At least part (14a) of the platinum-containing contact may comprise platinum silicide which may be formed by annealing to convert at least part of the platinum to platinum silicide. An ohmic contact (13) to the substrate (11) is also provided. A guard ring (16) or field plate may be provided. The Schottky contact exhibits lower forward resistance, lower reverse current and higher reverse breakdown voltage than heretofore available designs.

FIG. 1.

## SILICON CARBIDE SCHOTTKY DIODE AND METHOD OF MAKING SAME

This invention relates to Schottky diodes and more particularly to silicon carbide Schottky diodes and methods of forming such Schottky diodes.

Silicon carbide is a perennial candidate for use as a semiconductor material because of its wide band gap, high thermal conductivity, high breakdown electric field, low dielectric constant and high temperature stability. These characteristics give silicon carbide excellent semiconducting properties, and electronic devices made from silicon carbon may be expected to perform at higher temperatures, higher power levels, and at higher radiation densities than devices made from the most commonly used semiconductor materials such as silicon. Silicon carbide also has a high saturated electron drift velocity which raises the potential for devices which will perform at high speeds, and its high thermal conductivity and breakdown electric field permit high density device integration.

In order for silicon carbide to be employed for certain electronic devices, high performance Schottky contacts must be provided. High performance silicon carbide Schottky contacts are characterized by a low forward resistance, a low reverse leakage current and high reverse breakdown voltage. Moreover, the contact must be thermally stable and reliable at high temperatures, and the contact characteristics must not change significantly at high temperatures. It will also be realized by those having skill in the art that high performance Schottky contacts themselves are not sufficient. Fully operational, high performance Schottky diodes must be produced for use as discrete and integrated devices.

The art has heretofore attempted to fabricate silicon carbide Schottky contacts using gold metalization. See for example an article entitled *Charge Multiplication In Au-SiC (6H) Schottky Junctions*, G.H. Glover, Journal of Applied Physics, Vol. 46, No. 11, November 1975, pp. 4842-4844 in which gold dots were evaporated onto silicon carbide samples to test the avalanche multiplication rate for carriers in 6H-SiC. Unfortunately, gold Schottky contacts deteriorate rapidly at temperatures above 350°C or less, thereby negating the high temperature performance advantage of silicon carbide.

Another attempt at obtaining high temperature silicon carbide Schottky contacts is described in U.S. Patent Application Serial No. 262,400 to N.A. Papanicolaou, entitled *Platinum Silicide Contact On β-Silicon Carbide*, which discloses platinum and platinum silicide Schottky contacts on β-silicon carbide. As is well known to those having skill in the art, crystalline silicon carbide exists in more than 100 hexagonal and rhombohedral polytypes commonly known as α-SiC and one zincblende cubic polytype, referred to as β-SiC. According to the Papanicolaou specification, β-SiC is preferred because of its higher electron mobility especially at elevated temperatures, and its smaller energy gap than α-SiC.

It is an object of the invention to provide a high performance silicon carbide Schottky contact.

It is a further object of the present invention to provide a silicon carbide Schottky contact having lower forward resistance, lower reverse current and a higher reverse breakdown voltage than has been heretofore described.

It is yet another object of the invention to provide a high performance silicon carbide Schottky diode which incorporates a higher performance Schottky contact.

These and other objects are satisfied according to the present invention, by providing a silicon carbide Schottky contact comprising α-silicon carbide, more particularly 6H-α silicon carbide, and a platinum-containing contact on the 6H-α silicon carbide. According to the invention it has unexpectedly been found that the use of α-silicon carbide, and 6H-α silicon carbide in particular, provides improved device characteristics. It is theorized that improved device characteristics are obtained because of 6H-α silicon carbide's wider band gap compared to β-silicon carbide (i.e. 2.86eV compared to 2.2eV) and because of 6H-α silicon carbide's higher barrier height with platinum contacts compared to β-silicon carbide with platinum contacts (i.e. 1.71V compared to 1.1V), notwithstanding 6H-α silicon carbide's lower electron mobility compared to β-silicon carbide (i.e. 300 $cm^2/V \cdot s$ compared to 1000 $cm^2/V \cdot s$). Low forward resistance, low reverse current and high reverse breakdown voltage is thus provided. In particular, a forward resistance less than $3.2 \times 10^3$ $\Omega/cm^2$, a reverse current well below 1μA and a reverse breakdown voltage as high as 95V or more may be provided.

According to the invention, the platinum containing contact may be pure platinum, or in a preferred embodiment at least part of the platinum containing contact may be platinum silicide. Platinum silicide may be formed by annealing at 600°C for at least 15 minutes to convert at least part of the platinum to platinum silicide.

According to another aspect of the invention the high performance silicon carbide Schottky contact is incorporated into a high performance Schottky diode. The Schottky diode includes a heavily doped n+ 6H-α silicon carbide substrate and a lightly doped (n-) layer of 6H-α silicon carbide thereon, with the platinum containing Schottky contact on the n- layer. The n+ substrate provides high diode conductivity (low forward resistance) while the lightly doped n- layer provides high diode reverse breakdown voltage. An ohmic contact, for example nickel, may be provided on the n+ layer. Optionally a p-type silicon carbide guard ring may be provided in the n- layer under the periphery of the platinum containing contact, to enhance the reverse breakdown characteristics. Alternatively, a field plate may be provided over the periphery of the contact.

The Schottky diode of the present invention may be fabricated by heavily doping 6H-α silicon carbide substrate with nitrogen during crystal growth, to form the n+ layer. A thin n-layer may be epitaxially formed using chemical vapor deposition or other known techniques. Platinum may be deposited on the n- layer and then annealed at high temperature to convert at least a part of the platinum to platinum silicide. Alternatively, layers of platinum and silicon may be formed on the n- layer and annealed to convert to platinum silicide, or platinum silicide may be deposited on the n- layer

In the accompanying drawings:

Figure 1 illustrates a schematic cross section of a first embodiment of a Schottky diode according to the present invention.

Figure 2 illustrates a schematic cross section of a second embodiment of a Schottky diode according to the present invention.

Figures 3a - 3f are graphical illustrations of voltage versus current characteristics of Schottky diodes according to the present invention.

In the drawings and specification, there have been disclosed typical preferred embodiments of the invention and, although specific terms are employed, they are used in a generic and descriptive sense only and not for purposes of limitation, the scope of the invention being set forth in the following claims. The present invention now will be described more fully hereinafter with reference to the accompanying drawings, in which a preferred embodiment of the invention is shown. Like numbers refer to like elements throughout. For greater clarity, the thickness of the layers has been exaggerated.

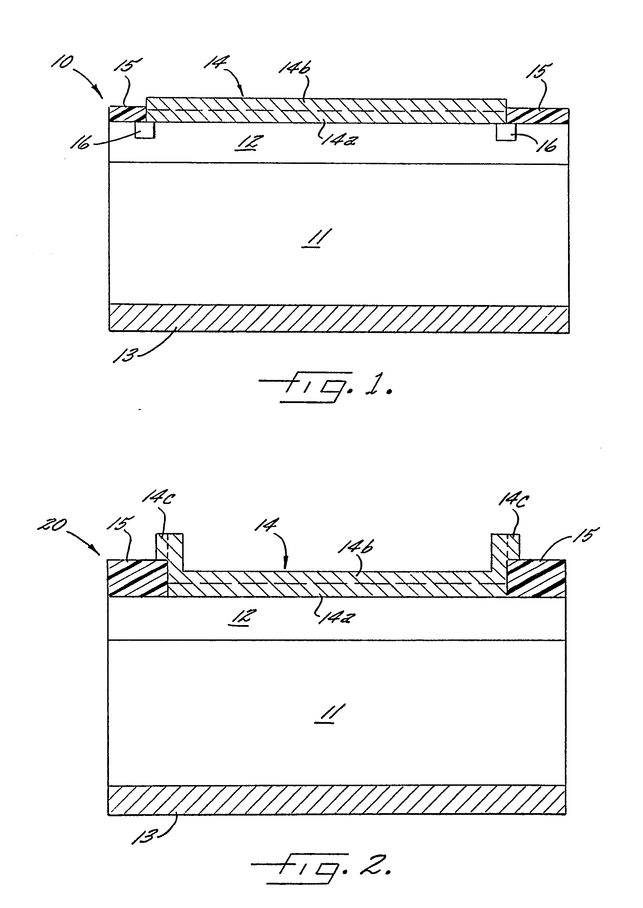

Referring now to Figure 1 a Schottky diode **10** according to the present invention is illustrated. The Schottky diode **10** includes an n+ 6H-α silicon carbide substrate **11** preferably 10-15 mils thick. Substrate **11** is heavily doped n+ to provide high conductivity (low resistance) in the forward direction. Substrate **11** is preferably doped with nitrogen at a concentration of $1 \times 10^{18}$ carriers per cubic centimeter or higher. Substrate **11** may be grown using sublimation growth techniques as described in U.S. Patent No. 4,866,005 issued 12 September 1989, entitled "Sublimation of Silicon Carbide to Produce Large, Device Quality Single Crystals of Silicon Carbide".

A lightly doped n- epitaxial layer **12** of 6H-α silicon carbide, preferably 1-4 μm thick is formed on substrate **11**. This thin lightly doped layer provides a high reverse breakdown voltage for the Schottky diode and is doped with $1 \times 10^{17}$ or fewer carriers per cubic centimeter. Nitrogen is the preferred dopant although phosphorous or other dopants may be used. Layer **12** may be formed by chemical vapor deposition or other known epitaxial techniques. It will be understood by those having skill in the art that in order to achieve a carrier concentration of less than $10^{17}$, nitrogen dopant does not need to be be added because nitrogen is naturally incorporated in the 6H-α silicon carbide to a certain extent during chemical vapor deposition.

Schottky diode **10** also includes an ohmic contact **13** on back side of substrate **11**. The ohmic contact is preferably 4000-5000Å of nickel although other conventional contact materials such as tantalum silicide, gold, gold/ tantalum or other alloys may be employed. Ohmic contact **13** may be deposited by sputtering, evaporation or other conventional techniques, followed by a high temperature (for example 1000°C) anneal. It will be understood by those having skill in the art that because of the high temperature anneal, ohmic contact **13** is preferably formed before Schottky contact **14**.

Still referring to Figure 1 a Schottky contact **14** containing platinum is formed on n- layer **12**. As shown in Figure 1 at least part of the platinum **14a** is converted to platinum silicide by high temperature annealing, for example by annealing at 600°C for 15 minutes. The platinum silicide layer **14a** forms a stable high performance Schottky contact at temperatures up to 800°C. Platinum containing layer **14** is preferably less than 2000Å thick, and may be deposited using common techniques, for example sputtering or evaporation, and patterned by common photolithographic techniques, for example lift-off. As is well known to those having skill in the art, the platinum silicide conversion process consumes a portion of n- layer **12**. To reduce or eliminate silicon carbide consumption, platinum silicide may be directly deposited and annealed to form a unitary structure. Alternating layers of platinum and silicon may also be deposited and annealed to convert the alternating layers to platinum silicide.

A Schottky diode fabricated as described in Figure 1 has been found to provide improved diode characteristics compared to known platinum on β-silicon carbide diodes. The diodes formed according to the present invention have a higher forward resistance of less than $3.2 \times 10^3$ Ω/cm². They exhibit a reverse current which is typically below measurable levels for reverse voltages below 10 volts and less than $1 \times 10^{-6}$ amp for reverse voltages below the breakdown voltage. A breakdown voltage of about -95 volts for a carrier dopant level in n-layer 12 of $4 \times 10^{-16}$ carriers per cubic centimeter is also exhibited.

Referring again to Figure 1 a guard ring 16 around the periphery of Schottky contact 14 is also included. Guard ring 16, which may be a ring of p-type 6H silicon carbide, prevents formation of a microplasma around the periphery of the Schottky diode which causes permanent damage to the Schottky diode due to the corona effect. Guard ring 16 forms a pn-junction which breaks down before the Schottky junction to create an avalanche effect and prevent breakdown of the Schottky contact. The guard ring 16 is doped at a level such that the pn-junction formed between guard ring 16 and n-layer 12 is reverse biased at the breakdown voltage of the Schottky diode. Guard ring 16 may be doped with aluminum or boron at a doping concentration of $10^{17}$-$10^{18}$ carriers per cubic centimeter and may be formed by high temperature ion implantation before formation of the Schottky contact 14. A ring pattern may be formed in a mask layer of silicon dioxide, silicon nitride and/or polycrystalline silicon and ions may be implanted through the ring in the mask. After implantation a shallow etch may be performed prior to removal of the implant mask so that the guard ring may be seen at the surface after removal of the mask, and the Schottky contact 14 aligned thereto.

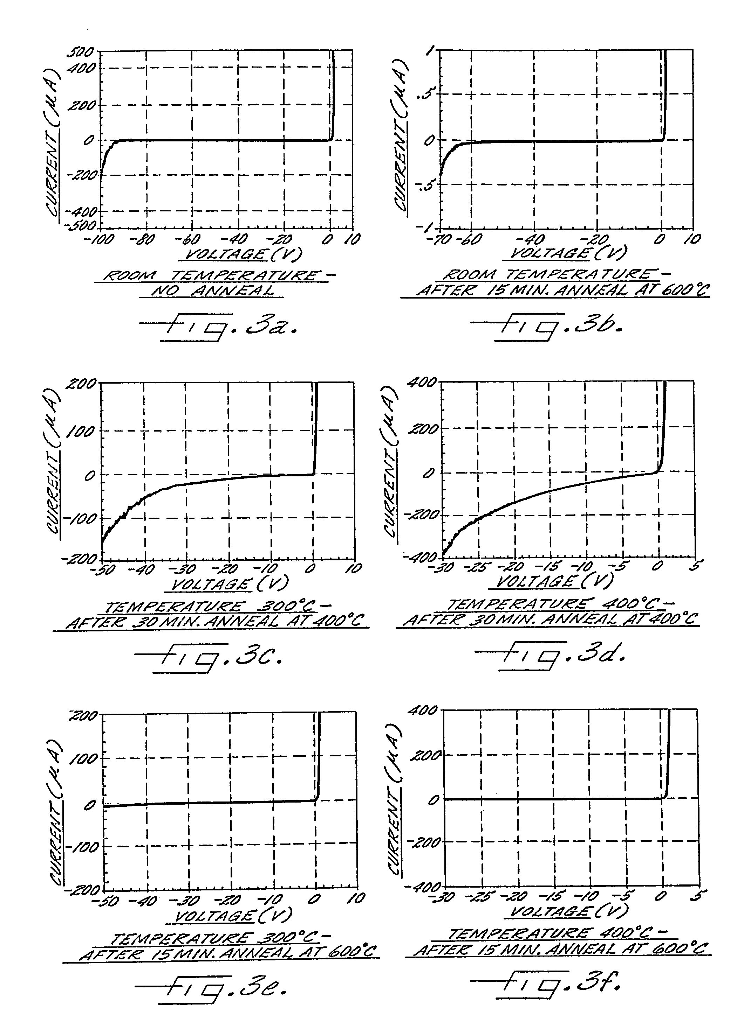

Referring now to Figure 2 a second embodiment of a Schottky diode according to the present invention is described. Schottky diode 20 of Figure 2 is identical to Schottky diode 10 of Figure 1 except that the guard ring of Figure 1 is replaced by a field plate region at 14c. Schottky contact 14 may be deposited by sputtering, evaporation or other common techniques, and may be patterned by common photolithographic techniques, for example lift-off. It will be understood by those having skill in the art that region 14c of Schottky contact 14 in combination with silicon dioxide or other insulator layer 15 and n- silicon carbide layer 12 lying thereunder forms a metal- insulator- semiconductor (MIS) structure. The MIS structure creates a depletion region in the semiconductor layer 12 at the periphery of the Schottky contact region 14a, which lowers the effective carrier concentration and prevents contact breakdown.

Referring now to Figure 3, the impact of annealing on the characteristics of the Schottky diode will now be described. The measurements of Figure 3 were made on Schottky diodes constructed as described with respect to Figure 1. Referring now to Figure 3a, the current - voltage (I-V) characteristics of a Schottky diode according to the present invention at room temperature without any conversion of platinum to platinum silicide is shown. The breakdown voltage is very high (-95v), however the reverse current below this voltage is steadily increasing (about 300 nA at -60V). Referring now to Figure 3b it may be seen that a 15 minute anneal at 600°C lowers the breakdown voltage somewhat (to -70 volts) but dramatically lowers the reverse current below the breakdown voltage (i.e. current 15 nA at -60V) note the different scales in Figures 3a and 3b. Figures 3c and 3d illustrate that Schottky diode characteristics of the unannealed platinum are less preferable at elevated temperatures after a 30 minute anneal at 400°C. Referring to Figure 3c it may be seen that at 300°C reverse current is high and even higher at 400°C (Figure 3d). In contrast to Figures 3c and 3d, Figures 3e and 3f illustrate the high temperature characteristics of the Schottky diode after a 15 minute anneal at 600°C. Figure 3e illustrates that the Schottky diode exhibits very little leakage current and a breakdown voltage greater than -50 volts at 300°C. Similar characteristics are observed at 400°C (Figure 3f). From the I-V graphs of Figure 3 it may be seen that annealing at 600°C improves high temperature leakage current at the expense of lowering the reverse breakdown voltage.

In the drawings and specification, there have been disclosed typical preferred embodiments of the invention and, although specific terms are employed, they are used in a generic and descriptive sense only and not for purposes of limitation, the scope of the invention being set forth in the following claims.

## Claims

1. A Schottky contact comprising:
an α-silicon carbide layer; and
a platinum containing contact on said α- silicon carbide layer.

2. The Schottky contact of Claim 1 wherein said α-silicon carbide layer comprises 6H-α silicon carbide.

3. The Schottky contact of Claim 1 or 2 wherein said platinum containing contact comprises platinum.

4. The Schottky contact of Claim 1 or 2 wherein said platinum containing contact comprises platinum silicide.

5. The Schottky contact of Claim 1 or 2 wherein said platinum containing contact comprises a platinum silicide layer on said silicon carbide layer and a layer of platinum on said platinum silicide layer.

6. The Schottky contact of Claim 1 or 2 wherein said α-silicon carbide layer comprises an n+ layer of 6H-α silicon carbide and an n- layer of 6H-α silicon carbide on said n+ layer, with said platinum-containing contact being on said n- layer.

7. The Schottky contact of Claim 6 further comprising a p-type silicon carbide guard ring within said n- layer, lying under the periphery of said platinum containing contact.

8. The Schottky contact of Claim 6 further comprising a field plate at the periphery of said platinum-containing contact.

9. The Schottky contact of Claim 6, 7 or 8 further comprising an ohmic contact on an exposed side of said n+ layer, to thereby form a Schottky diode.

10. A Schottky diode comprising:
an n+ 6H-α silicon carbide substrate;
an ohmic contact on one side of said substrate;
an n- 6H-α silicon carbide epitaxial layer on the opposite side of said substrate; and
a platinum silicide Schottky contact on said n- layer.

11. The Schottky diode of Claim 10 wherein said n+ layer is doped with nitrogen at a concentration greater than $10^{18}$ carriers per cubic centimeter.

12. The Schottky diode of Claim 10 or 11 wherein said n- layer is doped with nitrogen at a concentration less than $10^{17}$ carriers per cubic centimeter.

13. The Schottky diode of Claim 10, 11 or 12 wherein said platinum silicide Schottky contact is less than 2000Å thick.

14 . The Schottky diode of Claim 10, 11, 12 or 13 wherein said ohmic contact comprises nickel.

15 . A method of forming a Schottky contact comprising the steps of:
providing a 6H-α silicon carbide substrate; and
forming a platinum containing contact on said 6H-α silicon carbide substrate.

16 . The method of Claim 15 wherein said forming step comprises the steps of:
forming a platinum contact on said 6H-α silicon carbide substrate; and
converting at least part of said platinum contact to platinum silicide.

17. The method of Claim 16 wherein said converting step comprises the step of annealing said platinum contact.

18. The method of Claim 17 wherein said annealing step comprises the step of heating said platinum contact at a temperature of at least 600° C for at least 15 minutes.

19. The method of Claim 16 wherein said converting step comprises the step of converting all of said platinum contact to platinum silicide.

20. The method of Claim 15 wherein said forming step comprises the steps of:
forming a platinum silicide contact on said 6H-α silicon carbide layer.

21. The method of Claim 15 wherein said forming step comprises the steps of:
forming alternating layers of platinum and silicon on said 6H-α silicon carbide layer; and
converting said alternating layers of platinum and silicon to silicon carbide.

22. The method of Claim 15 wherein said providing step comprises the steps of:
providing an n+ 6H-α silicon carbide substrate;
epitaxially forming an n- layer of 6H-α silicon carbide on said substrate; and
wherein said forming step comprises the step of forming a platinum-containing contact on said n- layer.

Fig. 1.

Fig. 2.

ROOM TEMPERATURE -
NO ANNEAL

Fig.3a.

ROOM TEMPERATURE -
AFTER 15 MIN. ANNEAL AT 600°C

Fig.3b.

TEMPERATURE 300°C -
AFTER 30 MIN. ANNEAL AT 400°C

Fig.3c.

TEMPERATURE 400°C -
AFTER 30 MIN. ANNEAL AT 400°C

Fig.3d.

TEMPERATURE 300°C -
AFTER 15 MIN. ANNEAL AT 600°C

Fig.3e.

TEMPERATURE 400°C -
AFTER 15 MIN. ANNEAL AT 600°C

Fig.3f.